# EUROPÄISCHE PATENTSCHRIFT

(11) **EP 0 643 152 B1**
(45) Veröffentlichungstag und Bekanntmachung des Hinweises auf die Patenterteilung: **15.07.1998**
(21) Anmeldenummer: 94202508.1
(22) Anmeldetag: 01.09.1994
(51) Int. Cl.: C23C 16/34, C23C 16/36

(54) **Schneidwerkstoff**
Cutting tool
Outil de coupe

(30) Priorität: 09.09.1993 AT 1816/93
(43) Veröffentlichungstag der Anmeldung: 15.03.1995
(73) Patentinhaber: PLANSEE TIZIT GESELLSCHAFT M.B.H., 6600 Reutte/Tirol (AT)
(72) Erfinder: Garber, Erwin, A-6600 Lechaschau (AT); Schintlmeister, Wilfried, Dr., A-6600 Reutte (AT); Wallgram, Wolfgang, A-6600 Breitenwang (AT)
(74) Vertreter: Lohnert, Wolfgang, Dr.

(56) Entgegenhaltungen:
- EP-A- 0 031 805
- EP-A- 0 043 781
- EP-A- 0 143 889
- WO-A-90/11156
- DD-C- 144 566
- FR-A- 2 442 718
- GB-A- 2 135 337
- US-E- R E29 420
- Kenneth J A Brookers, Ed.: World Directory and Handbook of Hardmetals and Hard Materials, Fifth Edition, 1992, Seiten D381-D383, International Carbide Data (Publ.), Hertfordshire EN4 8DN, Uni

## Beschreibung

Die Erfindung betrifft einen Schneidwerkstoff, bestehend aus einem Cermet-Grundmaterial mit, im wesentlichen, mehr als 8 und bis zu 25 Gew.% Kobalt und/oder Nickel, bis zu 1 Gew.% Aluminium, 10 - 70 Gew.% Titan, bis zu 9 Gew.% Zirkon, bis zu 9 Gew.% Hafnium, bis zu 19 Gew.% Tantal, bis zu 9 Gew.% Niob, bis zu 4 Gew.% Vanadium, bis zu 3 Gew.% Chrom, bis zu 20 Gew.% Molybdän, bis zu 33 Gew.% Wolfram, bis zu 10 Gew.% Stickstoff, Rest Kohlenstoff, wobei der Kohlenstoff und/oder Stickstoff im wesentlichen in Form von einem oder mehreren Karbiden und/oder Nitriden und/oder Karbonitriden vorliegt; sowie aus einer auf dem Grundmaterial mittels des CVD-Verfahrens aufgebrachten Hartstoffbeschichtung mit einem mehrlagigen, mindestens eine Oxidschicht aus der Gruppe Aluminiumoxid, Zirkonoxid und deren Mischungen aufweisenden, Schichtaufbau, der neben der bzw. den Oxidschichten ein oder mehrere Schichten aus der Gruppe Titankarbid, Titannitrid, Titanborid, Titanoxid, Zirkonkarbid, Zirkonnitrid und deren Mischungen, aufweist.

Cermets sind im Vergleich zu herkömmlichen Hartmetall-Schneidwerkstoffen dadurch gekennzeichnet, daß sie vielfach Hartstoffe in Form von Nitriden und/oder Karbonitriden aufweisen und daß der Anteil an Wolframkarbid sehr klein ist. Als Bindemetalle werden in der Regel Mischungen von Nickel und Kobalt, aber auch jedes dieser Metalle in reiner Form verwendet. Anteile an Eisen und Sauerstoff sind für Cermets nicht typisch. Durch die üblichen Herstellungsprozesse sind jedoch Verunreinigungen der Cermets mit bis zu 0,6 Gew.% von jedem dieser Elemente nicht auszuschließen, wobei sich in der Regel das Eisen im Binder und der Sauerstoff in den Hartstoffen einlagert.

Auch bei Cermets ist es üblich und bekannt, die Verschleißfestigkeit durch einen Hartstoffüberzug des Grundmaterials zu verbessern. Problematisch beim Beschichten von Cermet-Werkstoffen ist es jedoch, vermutlich aufgrund des geringen Wolframkarbid-Anteiles, daß es insbesondere bei Beschichtungstemperaturen über 900°C, insbesondere bei Cermets mit hohen Bindemetall-Gehalten, zu einer starken Diffusion der Bindemetalle Nickel und/oder Kobalt aus dem Grundmaterial in die Überzugsschicht kommt, was die Schichtabscheidung und die Verschleißeigenschaften negativ beeinflußt.

Während übliche Hartstoffschichten auf Karbid-, Nitrid- und Boridbasis auch als verschleißfeste Anwendung bei Schneidwerkzeugen bereits bei Beschichtungstemperaturen von etwa 700°C mit Hilfe des CVD-Verfahrens abgeschieden werden können, ist die Abscheidung von Aluminiumoxid mit Hilfe des konventionellen (thermischen) CVD-Verfahrens für verschleißfeste Anwendungen bei Temperaturen unter 900°C nicht möglich, da die verschleißfesten Modifikationen des Aluminiumoxids erst ab einer Abscheidetemperatur von mindestens 900°C erreicht werden können. Bei Anwendung eines plasmaunterstützten CVD-Verfahrens ist es zwar auch möglich, diese verschleißfesten Modifikationen bei tieferen Temperaturen zu erreichen; ein derartiges Beschichtungsverfahren ist jedoch gegenüber dem herkömmlichen CVD-Verfahren teurer.

Aus diesen Gründen ist es zu erklären, daß bis zum heutigen Zeitpunkt praktisch keine, bzw. keine Schneidwerkstoffe auf Cermet-Basis mit einem Aluminiumoxid-Überzug auf dem Markt erhältlich sind, obwohl bei derartigen Schneidwerkstoffen, insbesondere bei der Zerspanung von Stählen und Gußwerkstoffen, gute Eigenschaften zu erwarten waren.

Die EP 0 440 157 beschreibt zum Stand der Technik, daß es beim Beschichten von Cermets mit Titankarbid und Titankarbonitrid bei Beschichtungstemperaturen von etwa 1000°C zu einer starken Diffusion der bei Cermets üblichen Bindemetalle Kobalt und Nickel in den Überzug kommt und dadurch die Verschleißfestigkeit verschlechtert wird. Zur Vermeidung dieses nachteiligen Effektes wird vorgeschlagen, bei der Abscheidung von Karbonitriden dem Beschichtungsgas Acetonitril beizumengen, wodurch die Beschichtungstemperatur auf 700 bis 900°C abgesenkt werden kann. Eine Beschichtung von Cermets mit Aluminiumoxid ist dieser Veröffentlichung nicht zu entnehmen.

Aus den Veröffentlichungen "Influence of trace Impurities on the formation of α Al₂O₃ layers by CVD", H. Altena et al., Seiten 451-458 und "Formation of Whiskers on Al₂O₃ CVD layers", H. Altena et al., Seiten 428-434, beide aus den Proceedings of the 4th European CVD Conference Eindhoven 1983, ist zu ersehen, daß Spuren von Nickel und Kobalt die Qualität von Aluminiumoxidschichten, die mit dem CVD-Verfahren abgeschieden werden, negativ beeinflußt.

Die EP 0 492 059 beschreibt ein beschichtetes Cermet, wobei als möglicher Schichtaufbau ein oder mehrere Schichten aus der Gruppe Titankarbid, Titankarbonitrid, Titannitrid und Aluminiumoxid genannt sind. Ein spezieller bevorzugter Schichtaufbau ist dieser Vorveröffentlichung nicht zu entnehmen. Aus der Vorveröffentlichung geht ebenfalls die Anweisung hervor, bei der Beschichtung von Cermets mit Hartstoffschichten durch das CVD-Verfahren möglichst geringe Beschichtungstemperaturen anzuwenden, um eine Diffusion des Binders in die Hartstoffschicht zu vermeiden. Darüberhinaus wird durch ein spezielles Sinterverfahren des Cermets eine harte, an Binder verarmte Zone an der zu beschichtenden Oberfläche geschaffen.

Die EP 0 537 741 beschreibt einen beschichteten Cermet-Schneidwerkstoff, der in der Hartstoffphase des Grundwerkstoffes einen bestimmten Anteil an Zirkonoxid aufweist. Als geeignete Hartstoffschichten sind ein oder mehrere Schichten aus der Gruppe Titankarbid, Titannitrid, Titankarbonitrid, Titankarbooxid, Titankarbooxinitrid und Aluminiumoxid genannt, wobei kein bevorzugter Schichtaufbau zu entnehmen ist. Wesentlich bei dieser Vorveröffentlichung ist, daß der Bindergehalt des Cermets sehr gering und mit 8 Gew.% begrenzt ist, so daß Diffusionsprobleme des Binders in die Hartstoffschichten nicht so stark auftreten.

Die WO 92/17623 beschreibt einen Schneidwerkstoff, der unter anderem aus einem Cermet-Grundkörper hergestellt sein kann, der eine Beschichtung aus Aluminiumoxid aufweist, die mittels eines plasmaunterstützten CVD-Verfahrens bei Temperaturen zwischen 400 und 750°C abgeschieden wurde. Als mögliche Zwischenschichten zwischen Grundmaterial und Aluminiumoxidschicht sind eine oder mehrere Lagen von Karbiden, Karbonitriden, Nitriden, Boriden und/oder Oxiden der Elemente der Gruppen IVa bis VIa des Periodensystems genannt. Nachteilig bei einer derartigen Ausführung eines Schneidwerkstoffes ist, daß das Aufbringen der Aluminiumoxidschicht durch das plasmaunterstützte CVD-Verfahren relativ teuer ist.

Aufgabe der vorliegenden Erfindung ist es daher, Cermet-Schneidwerkstoffe, die mit Aluminiumoxid beschichtet sind, zur Verfügung zu stellen, die auch mit hohen Bindemetallgehalten ein ausgezeichnetes Verschleißverhalten aufweisen und gleichzeitig kostengünstig herstellbar sind.

Erfindungsgemäß wird dies dadurch erreicht, daß die unmittelbar an das Grundmaterial angrenzende Schicht eine Titannitridschicht und/oder eine Titankarbonitridschicht mit einem Stickstoffanteil von mindestens 5 Atom% ist und die Oxidschicht bei einer Beschichtungstemperatur von mindestens 900°C abgeschieden ist.

Überraschenderweise hat sich gezeigt, daß schon bei Anordnung einer sehr dünnen Titannitrid- und/oder Titankarbonitridschicht unmittelbar auf dem Cermet-Grundmaterial bei der weiteren Beschichtung eine Diffusion der Bindemetalle Kobalt und Nickel über diese Schichten hinaus in die nachfolgenden Schichten verhindert und damit die Verschleißfestigkeit deutlich verbessert wird. Die unmittelbar auf dem Grundmaterial aufgebrachte Titannitrid- und/oder Titankarbonitridschicht wirkt also bereits bei geringer Schichtstärke als wirksame Diffusionsbarriere.

Darüberhinaus konnte auch der Effekt beobachtet werden, daß mit zunehmendem Anteil der Elemente Nickel und/oder Kobalt in dieser Diffusionsbarriere die Oberfläche dieser Schichten zunehmend rauher und warziger werden und damit automatisch auch die Oberflächen der einzelnen Schichten des nachfolgenden Schichtaufbaues, vor allem der Oxidschichten. Deshalb ist es günstig, bei der Abscheidung dieser Titannitrid- und/oder Titankarbonitridschicht die Abscheidungstemperatur möglichst niedrig zu halten, um auch den Anteil an Nickel und/oder Kobalt aus dem Grundmaterial in diesen Schichten möglichst niedrig zu halten. Doch selbst bei ungünstigen Bedingungen beim Abscheiden dieser Diffusionsbarriere ist die Verschleißfestigkeit von den erfindungsgemäßen Cermets gegenüber Cermets mit Oxidschichten, die keine Titannitrid- und/oder Titankarbonitridschicht unmittelbar am Grundmaterial aufweisen, deutlich verbessert.

Die gebräuchlichsten Grundmaterialzusammensetzungen des erfindungsgemäßen Schneidwerkstoffes enthalten Nickel und/oder Kobalt als Binder in einer Menge von 10 - 20 Gew.%, während der Wolframanteil im Grundmaterial nicht über 4,5 - 24 Gew.% hinausgeht.

Eine besonders vorteilhafte Schneidwerkstoff-Zusammensetzung besteht im wesentlichen aus 10 - 18 Gew.% Kobalt und/oder Nickel bis zu 0,5 Gew.% Aluminium, 30 - 60 Gew.% Titan, 5 - 19 Gew.% Tantal, bis zu 5 Gew.% Niob, bis zu 3 Gew.% Vanadium, 3 - 20 Gew.% Wolfram, bis zu 15 Gew.% Molybdän, bis zu 2 Gew.% Chrom, 3 - 8 Gew.% Stickstoff, Rest Kohlenstoff.

Als unmittelbar an das Grundmaterial angrenzende Schicht hat sich insbesondere eine reine Titannitridschicht und/oder Titankarbonitridschicht mit einem Stickstoffanteil von mindestens 10 Atom% und einer Gesamtschichtstärke zwischen 0,5 und 5 µm bewährt.

Für den weiteren Schichtaufbau ist es vorteilhaft wenn er ein oder mehrere Oxidschichten mit einer Gesamtschichtstärke von 1 - 7 µm enthält.

Besonders vorteilhaft für spezielle Anwendungen ist es, wenn der weitere Schichtaufbau aus mehreren Alumiumoxidschichten jeweils im Wechsel mit einer oder mehreren Schichten aus der Gruppe Titankarbonitrid, Titanoxikarbonitrid, Titannitrid und Titanoxinitrid mit Einzelschichtstärken von 0,1 - 3 µm und einer Gesamtschichtstärke von 2 - 15 µm besteht.

Auch ein erfindungsgemäßer Schneidwerkstoff, der als weiteren Schichtaufbau neben einer oder mehreren Oxidschichten eine oder mehrere Schichten aus der Gruppe Titankarbid, Titannitrid, Titanborid und deren Mischungen mit einer Dicke von jeweils 0,5 - 5 µm aufweist, ist vorteilhaft einsetzbar.

Im folgenden wird die Erfindung anhand von Herstellungsbeispielen und Zerspanungstests näher erläutert.

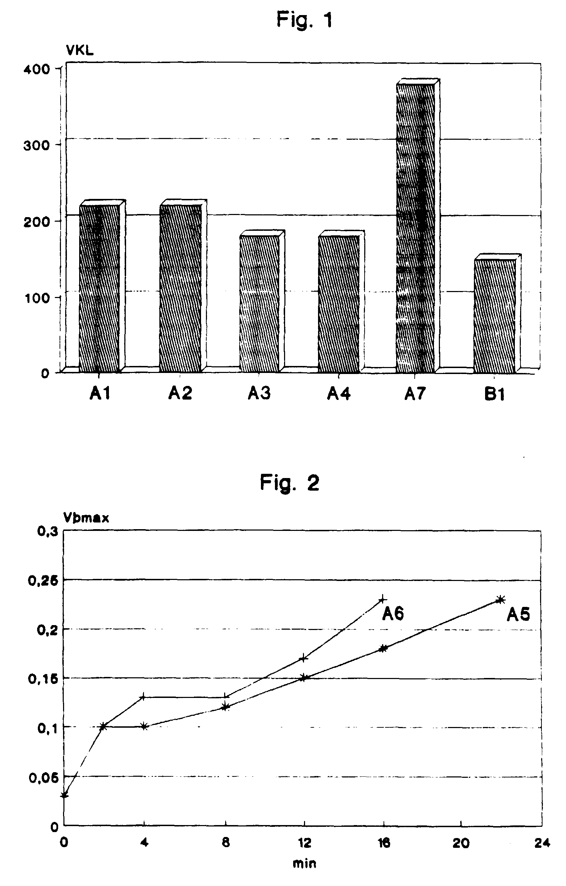

Die Figuren 1 - 4 zeigen das Verschleißverhalten einzelner nach den Herstellungsbeispielen gefertigter Muster nach vergleichenden Zerspanungstests

### Herstellungsbeispiele:

Zur Untersuchung des Verschleißverhaltens wurden eine Anzahl unterschiedlicher Muster von Wendeschneidplatten nach Tabelle 1 hergestellt.

Zur Beschichtung nach dem CVD Verfahren wurden die Wendeschneidplatten in einen Rezipienten eingebaut, unter Schutzgas aufgeheizt und unter Normaldruck die einzelnen Schichten mit den folgenden Parametern aufgebracht.

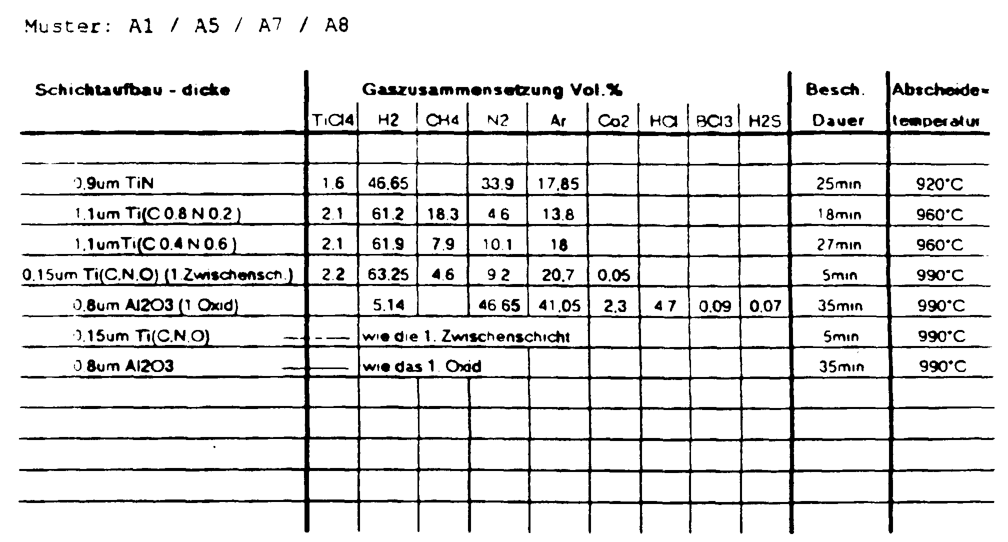

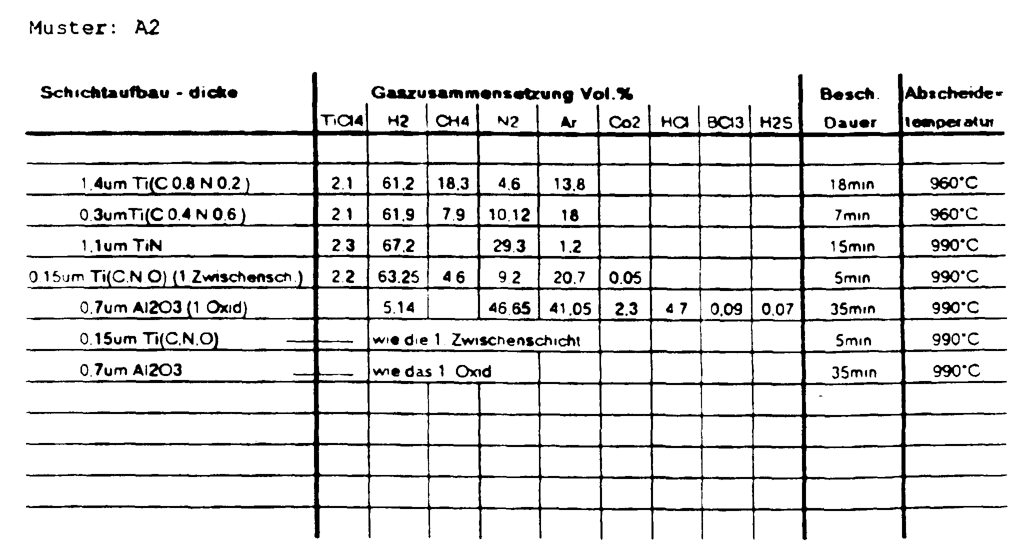

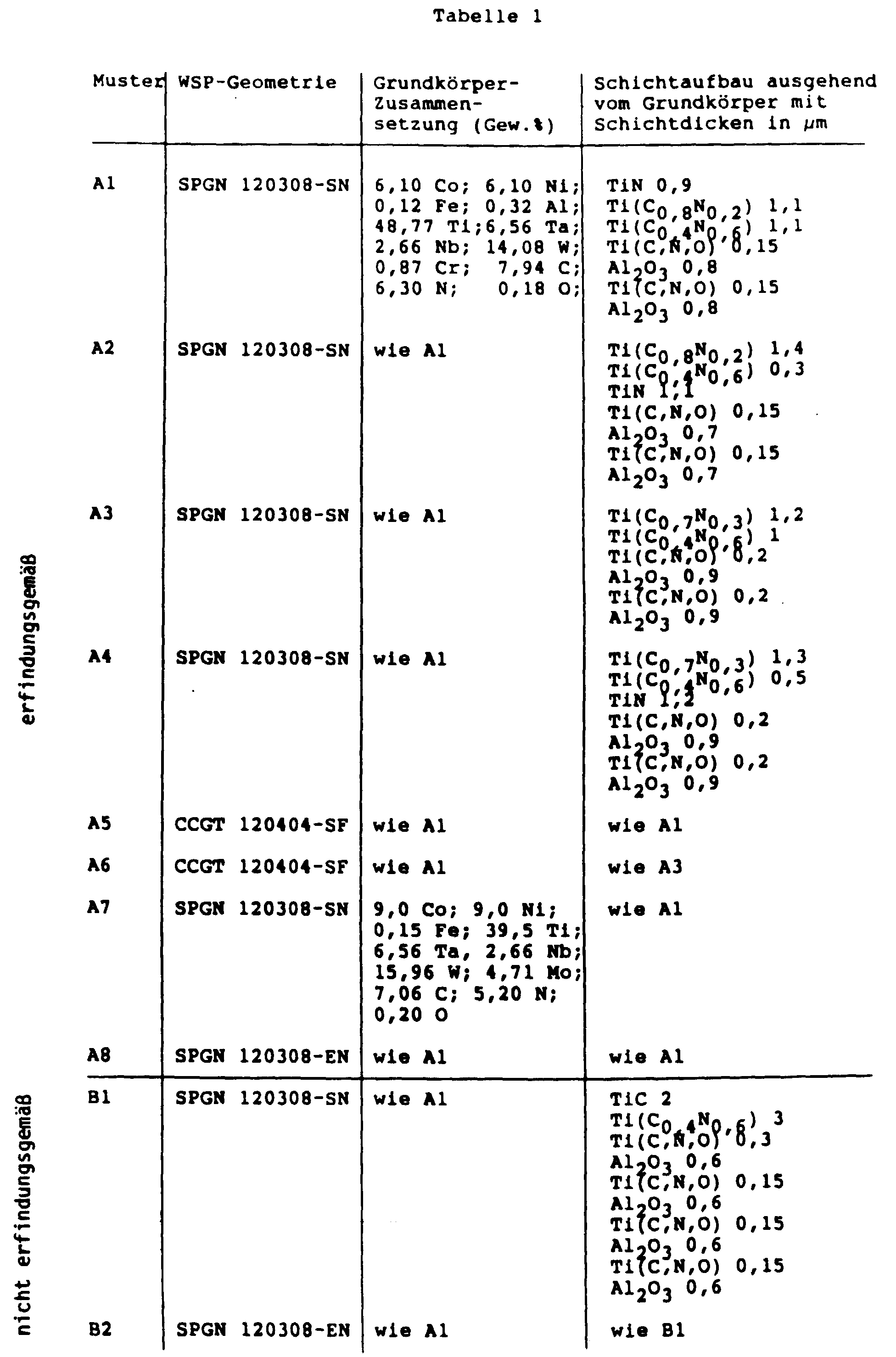

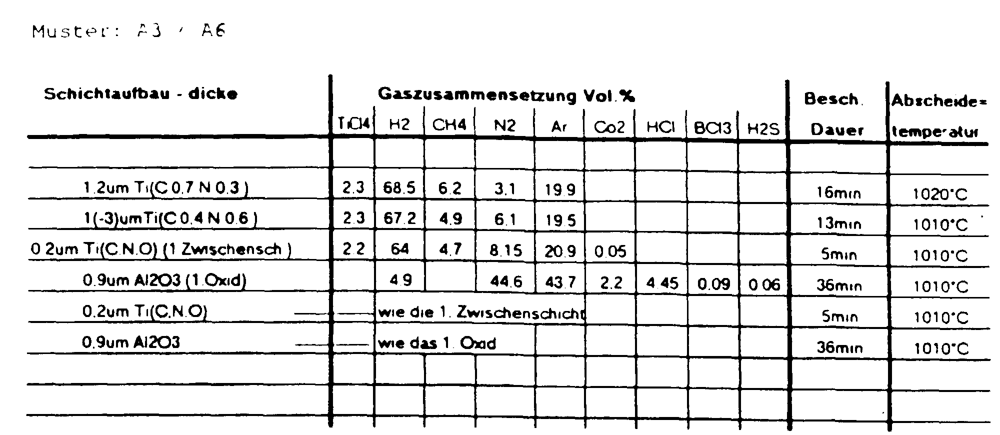

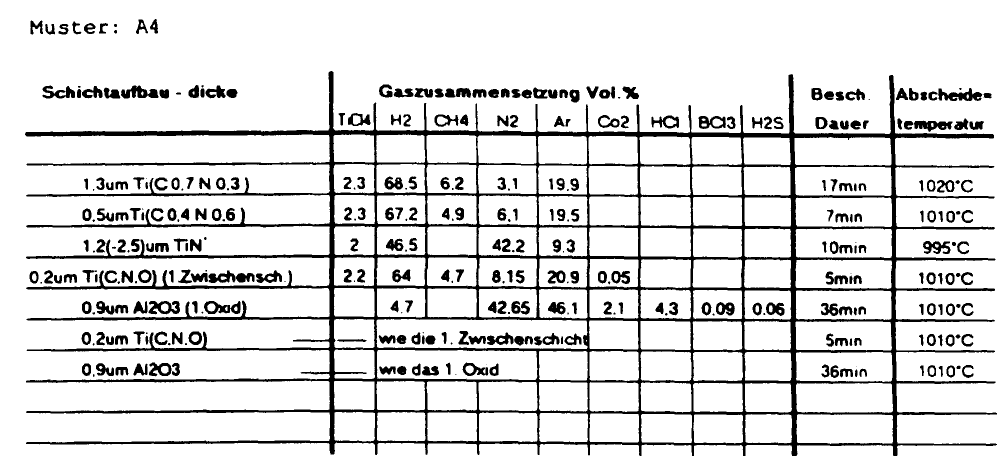

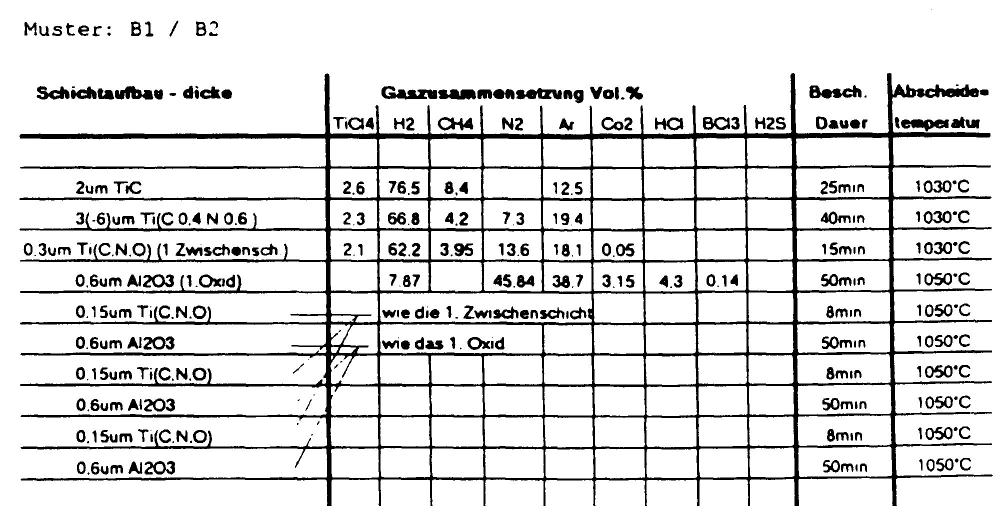

### Zerspanungstests:

In einem ersten Zerspanungstest wurden die Muster A1, A2, A3, A4, A7 und B1 einem Vorschubklassentest unterzogen. Bei diesem Test werden vier am Umfang einer zylindrischen Prüfvorrichtung je um 90° versetzt eingespannte Leisten mit einer Dicke von 55 mm abgedreht. Die Vorschubklasse (VKL) ist jener Vorschub, bei dem mindestens 75 % der getesteten Schneidkanten eine Schlagzahl zwischen 100 und 500 erreichen, wobei mindestens 10 Schneidkanten getestet werden müssen. Beim vorliegenden Zerspanungstest wurde als Leistenwerkstoff Warmarbeitsstahl 1.2343 mit einer Festigkeit von 810 N/mm² verwendet. Das Abdrehen der Leisten erfolgte mit einer Schnittgeschwindigkeit von 200 m/min und einer Schnittiefe von 2,5 mm.

Aus Figur 1 ist der VKL-Wert der einzelnen Muster zu entnehmen. Bei den erfindungsgemäßen Mustern A3 und A4 erfolgte die Abscheidung der unmittelbar an das Grundmaterial angrenzenden Titankarbonitridschicht bei 1020°C während die Abscheidung der ersten Schicht bei den erfindungsgemäßen Mustern A1 und A2 bei Temperaturen von 920 bzw. 960°C erfolgte. Das bessere Verschleißverhalten bei den Mustern A1 und A2, bei denen diese Schichten bei tieferen Temperaturen abgeschieden wurden, ist zu erkennen.

In einem zweiten Zerspanungstest wurde Kohlenstoffstahl CK67 mit einer Festigkeit von 980 N/mm² mit einer Schnittgeschwindigkeit von 250 m/min, einem Vorschub von 0,1 mm/U und einer Schnittiefe von 1,5 mm unter Verwendung der Muster-Wendeschneidplatten A5 und A6 trocken gedreht. Figur 2 zeigt den aufgetretenen Freiflächenverschleiß in Abhängigkeit von der Zerspanungsdauer. Auch hier ist zu erkennen, daß beim erfindungsgemäßen Muster A5, bei dem die unmittelbar ans Grundmaterial grenzende Schicht bei einer tieferen Temperatur als beim erfindungsgemäßen Muster A6 abgeschieden wurde, ein kleinerer Verschleiß auftritt.

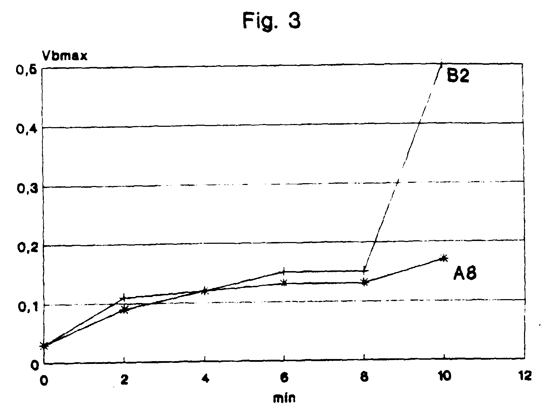

In einem dritten Zerspanungstest wurde Grauguß GG25 mit einer Schnittgeschwindigkeit von 250 m/min, einem Vorschub von 0,2 mm/U und einer Schnittiefe von 1,5 mm unter Verwendung der Muster-Wendeschneidplatten A8 und B2 trocken gedreht. Figur 3 zeigt die maximal aufgetretenen Verschleißmarkenbreiten an der Freifläche in Abhängigkeit von der Zerspanungsdauer.

## Patentansprüche

1. Schneidwerkstoff, bestehend aus einem Cermet-Grundmaterial mit, im wesentlichen, mehr als 8 und bis zu 25 Gew.% Kobalt und/oder Nickel, bis zu 1 Gew.% Aluminium, 10 - 70 Gew.% Titan, bis zu 9 Gew.% Zirkon, bis zu 9 Gew.% Hafnium, bis zu 19 Gew.% Tantal, bis zu 9 Gew.% Niob, bis zu 4 Gew.% Vanadium, bis zu 3 Gew.% Chrom, bis zu 20 Gew.% Molybdän, bis zu 33 Gew.% Wolfram, bis zu 10 Gew.% Stickstoff, Rest Kohlenstoff, wobei der Kohlenstoff und/oder Stickstoff im wesentlichen in Form von einem oder mehreren Karbiden und/oder Nitriden und/oder Karbonitriden vorliegt; sowie aus einer auf dem Grundmaterial mittels des CVD-Verfahrens aufgebrachten Hartstoffbeschichtung mit einem mehrlagigen, mindestens eine Oxidschicht aus der Gruppe Aluminiumoxid, Zirkonoxid und deren Mischungen aufweisenden, Schichtaufbau, der neben der bzw. den Oxidschichten ein oder mehrere Schichten aus der Gruppe Titankarbid, Titannitrid, Titanborid, Titanoxid, Zirkonkarbid, Zirkonnitrid und deren Mischungen, aufweist,
**dadurch gekennzeichnet**,
daß die unmittelbar an das Grundmaterial angrenzende Schicht eine Titannitridschicht und/oder eine Titankarbonitridschicht mit einem Stickstoffanteil von mindestens 5 Atom% ist und die Oxidschicht bei einer Beschichtungstemperatur von mindestens 900°C abgeschieden ist.

2. Schneidwerkstoff nach Anspruch 1, dadurch gekennzeichnet, daß das Grundmaterial 10 - 20 Gew.% Nickel und/oder Kobalt enthält.

3. Schneidwerkstoff nach Anspruch 1 oder 2, dadurch gekennzeichnet, daß das Grundmaterial 4,5 - 24 Gew.% Wolfram enthält.

4. Schneidwerkstoff nach Anspruch 1, dadurch gekennzeichnet, daß das Grundmaterial im wesentlichen aus 10 - 18 Gew.% Kobalt und/oder Nickel, bis zu 0,5 Gew.% Aluminium, 30 - 60 Gew.% Titan, 5 - 19 Gew.% Tantal, bis zu 5 Gew.% Niob, bis zu 3 Gew.% Vanadium, 3 - 20 Gew.% Wolfram, bis zu 15 Gew.% Molybdän, bis zu 2 Gew.% Chrom, 3 - 8 Gew.% Stickstoff, Rest Kohlenstoff besteht.

5. Schneidwerkstoff nach einem der Ansprüche 1 bis 4, dadurch gekennzeichnet, daß die unmittelbar an das Grundmaterial angrenzende Schicht eine reine Titannitridschicht oder eine Titancarbonitridschicht mit einem Stickstoff-Anteil von mindestens 10 Atom% ist.

6. Schneidwerkstoff nach einem der Ansprüche 1 bis 5, dadurch gekennzeichnet, daß die unmittelbar an das Grundmaterial angrenzende Schicht eine Dicke zwischen 0,5 und 5 µm aufweist.

7. Schneidwerkstoff nach einem der Ansprüche 1 bis 6, dadurch gekennzeichnet, daß der weitere Schichtaufbau ein oder mehrere Oxidschichten mit einer Gesamtschichtstärke von 1 - 7 µm enthält.

8. Schneidwerkstoff nach einem der Ansprüche 1 bis 6, dadurch gekennzeichnet, daß der weitere Schichtaufbau aus mehreren Aluminiumoxidschichten jeweils im Wechsel mit einer oder mehreren Schichten aus der Gruppe Titankarbonitrid, Titanoxikarbonitrid, Titannitrid und Titanoxinitrid mit Einzelschichtstärken von 0,1 - 3 µm und einer Gesamtschichtstärke von 2 - 15 µm besteht.

9. Schneidwerkstoff nach Anspruch 7, dadurch gekennzeichnet, daß der weitere Schichtaufbau zusätzlich zu einer oder mehreren Oxidschichten eine oder mehrere Schichten aus der Gruppe Titankarbid, Titannitrid, Titanborid und deren Mischungen mit einer Dicke von jeweils 0,5 - 5 µm aufweist.

## Claims

1. Cutting material, comprising a cermet base material, which substantially contains more than 8 and up to 25% by weight of cobalt and/or nickel, up to 1% by weight of aluminium, 10 - 70% by weight of titanium, up to 9% by weight of zirconium, up to 9% by weight of hafnium, up to 19% by weight of tantalum, up to 9% by weight of niobium, up to 4% by weight of vanadium, up to 3% by weight of chromium, up to 20% by weight of molybdenum, up to 33% by weight of tungsten, up to 10% by weight of nitrogen, the remainder being carbon, the carbon and/or nitrogen being present substantially in the form of one or more carbides and/or nitrides and/or carbonitrides; as well as comprising a hard material coating applied by CVD onto the base material and having a multi-ply layer structure, which comprises at least one oxide layer from the group of aluminium oxide, zirconium oxide and mixtures thereof and has, in addition to the oxide layer(s), one or more layers from the group titanium carbide, titanium nitride, titanium boride, titanium oxide, zirconium carbide, zirconium nitride and mixtures thereof,
characterized in
that the layer immediately adjoining the base material is a titanium nitride layer and/or a titanium carbonitride layer with a nitrogen component of at least 5 atom% and the oxide layer is deposited at a coating temperature of at least 900°C.

2. Cutting material according to claim 1, characterized in that the base material contains 10 - 20% by weight of nickel and/or cobalt.

3. Cutting material according to claim 1 or 2, characterized in that the base material contains 4.5 - 24% by weight of tungsten.

4. Cutting material according to claim 1, characterized in that the base material substantially comprises 10 - 18% by weight of cobalt and/or nickel, up to 0.5% by weight of aluminium, 30 - 60% by weight of titanium, 5 - 19% by weight of tantalum, up to 5% by weight of niobium, up to 3% by weight of vanadium, 3 - 20% by weight of tungsten, up to 15% by weight of molybdenum, up to 2% by weight of chromium, 3 - 8% by weight of nitrogen, the remainder being carbon.

5. Cutting material according to one of claims 1 to 4, characterized in that the layer immediately adjoining the base material is a pure titanium nitride layer or a titanium carbonitride layer having a nitrogen component of at least 10 atom%.

6. Cutting material according to one of claims 1 to 5, characterized in that the layer immediately adjoining the base material has a thickness of between 0.5 and 5 µm.

7. Cutting material according to one of claims 1 to 6, characterized in that the further layer structure comprises one or more oxide layers having an overall layer thickness of 1 - 7 µm.

8. Cutting material according to one of claims 1 to 6, characterized in that the further layer structure comprises a plurality of aluminium oxide layers each alternating with one or more layers from the group titanium carbonitride, titanium oxycarbonitride, titanium nitride and titanium oxynitride having individual layer thicknesses of 0.1 - 3 µm and an overall layer thickness of 2 - 15 µm.

9. Cutting material according to claim 7, characterized in that the further layer structure in addition to one or more oxide layers comprises one or more layers from the group titanium carbide, titanium nitride, titanium boride and mixtures thereof having a thickness of, in each case, 0.5 - 5 µm.

## Revendications

1. Matériau de coupe se composant d'une matière de base constituée d'un cermet contenant, essentiellement, plus de 8 et jusqu'à 25 % en poids de cobalt et/ou de nickel, jusqu'à 1 % en poids d'aluminium, 10 à 70 % en poids de titane, jusqu'à 9 % en poids de zirconium, jusqu'à 9 % en poids d'hafnium, jusqu'à 19 % en poids de tantale, jusqu'à 9 % en poids de niobium, jusqu'à 4 % en poids de vanadium, jusqu'à 3 % en poids de chrome, jusqu'à 20 % en poids de molybdène, jusqu'à 33 % en poids de tungstène, jusqu'à 10 % en poids d'azote, solde carbone, le carbone et/ou l'azote étant présents essentiellement sous forme d'un ou plusieurs carbures et/ou nitrures et/ou carbonitrures; ainsi que d'un revêtement en substance dure appliqué sur la matière de base au moyen d'un procédé de dépôt chimique en phase vapeur ou CVD, dont la structure en couches de plusieurs strates, qui comporte au moins une couche d'oxydes du groupe formé par l'oxyde d'aluminium, l'oxyde de zirconium et leurs mélanges, comporte en plus des couches d'oxydes une ou plusieurs couches du groupe formé par le carbure de titane, le nitrure de titane, le borure de titane, l'oxyde de titane, le carbure de zirconium, le nitrure de zirconium et leurs mélanges, caractérisé en ce que la couche immédiatement adjacente à la matière de base est une couche de nitrure de titane et/ou une couche de carbonitrure de titane à teneur atomique en azote d'au moins 5 %, et la couche d'oxyde est déposée à une température d'application d'au moins 900°C.

2. Matériau de coupe selon la revendication 1, caractérisé en ce que la matière de base contient de 10 à 20 % en poids de nickel ou de cobalt.

3. Matériau de coupe selon la revendication 1 ou 2, caractérisé en ce que en ce que la matière de base contient de 4,5 à 24 % en poids de tungstène.

4. Matériau de coupe selon la revendication 1, caractérisé en ce que la matière de base se compose essentiellement de 10 à 18 % en poids de cobalt et/ou de nickel, jusqu'à 0,5 % en poids d'aluminium, de 30 à 60 % en poids de titane, de 5 à 19 % en poids de tantale, jusqu'à 5 % en poids de niobium, jusqu'à 3 % en poids de vanadium, de 3 à 20 % en poids de tungstène, jusqu'à 15 % en poids de molybdène, jusqu'à 2 % en poids de chrome, de 3 à 8 % en poids d'azote, solde carbone.

5. Matériau de coupe selon l'une des revendications 1 à 4, caractérisé en ce que la couche immédiatement adjacente à la matière de base est une couche de nitrure de titane pur et/ou une couche de carbonitrure de titane à teneur atomique en azote d'au moins 10 %.

6. Matériau de coupe selon l'une des revendications 1 à 5, caractérisé en ce que l'épaisseur de la couche immédiatement adjacente à la matière de base est comprise entre 0,5 et 5 µm.

7. Matériau de coupe selon l'une des revendications 1 à 6, caractérisé en ce que la structure additionnelle de couche contient une ou plusieurs couches d'oxydes d'une épaisseur totale de couche de 1 à 7 µm.

8. Matériau de coupe selon l'une des revendications 1 à 6, caractérisé en ce que la structure additionnelle de couches se compose de plusieurs couches d'oxyde d'aluminium respectivement en alternance avec une ou plusieurs couches du groupe formé par le carbonitrure de titane, l'oxycarbonitrure de titane, le nitrure de titane et l'oxynitrure de titane, d'épaisseurs individuelles de 0,1 à 3 µm et d'une épaisseur totale de couche de 2 à 15 µm.

9. Matériau de coupe selon la revendication 7, caractérisé en ce que la structure additionnelle de couche comporte, en plus d'une ou plusieurs couches d'oxydes, une ou plusieurs couches du groupe formé par le carbure de titane, le nitrure de titane, le borure de titane et leurs mélanges, d'une épaisseur respective de 0,5 à 5 µm.
